# EUROPEAN PATENT APPLICATION

(11) **EP 1 930 938 A1**
(43) Date of publication of application: **11.06.2008**
(21) Application number: 06782800.4
(22) Date of filing: 17.08.2006
(51) Int. Cl.: H01L 21/304, B24B 37/00, C09K 3/14

(54) **POLISHING AGENT, METHOD FOR POLISHING SURFACE TO BE POLISHED, AND METHOD FOR MANUFACTURING SEMICONDUCTOR INTEGRATED CIRCUIT DEVICE**

(30) Priority: 09.09.2005 JP 2005261747
(71) Applicant: Asahi Glass Company, Limited, Chiyoda-ku Tokyo 100-8405 (JP)
(72) Inventor: TAKEMIYA, Satoshi, Tokyo 100-8405 (JP)
(74) Representative: Müller-Boré & Partner Patentanwälte
(86) International application number: PCT/JP2006/316187
(87) International publication number: WO 2007/029465

(57) **Abstract**

To provide a polishing compound which is capable of polishing SiC at a high removal rate, or capable of suppressing polishing of silicon dioxide in an insulating layer on the other hand, while polishing SiC at a high removal rate, in production of a semiconductor integrated circuit device, whereby it is possible to obtain a semiconductor integrated circuit device having a planarized multiplayer structure.

The present polishing compound comprising abrasive particles (A), an adjusting agent of removal rate (B) which is at least one selected from the group consisting of a benzotriazole, a 1H-tetrazole, a benzene sulfonic acid, phosphoric acid or organic phosphonic acid, an organic solvent (C) having a relative permittivity of from 15 to 80, a boiling point of from 60 to 250°C and a viscosity of from 0.5 to 60 mPa·S at 25°C ,and water (D).

## Description

### TECHNICAL FIELD

The present invention relates to a polishing technology to be used in a process for producing semiconductor integrated circuit devices. More specifically, the present invention relates to a polishing compound for chemical mechanical polishing which is suitable for polishing SiC as a constituting material of e.g. an insulation barrier layer, an etching stopper layer or an antireflection layer, and it relates to a method for polishing a surface to be polished and a method for producing a semiconductor integrated circuit device by using the polishing method.

### BACKGROUND ART

Recently, along with the progress in the integration and functionality of semiconductor integrated circuits, there has been a demand for development of micro-fabrication techniques for miniaturization and densification. Planarization techniques for interlayer insulating films and embedded wirings are important in semiconductor integrated circuit production processes, in particular, in a process of forming multilayered wirings. That is, as wirings are increasingly multilayered due to the miniaturization and densification in the semiconductor production processes, the degree of unevenness tends to increase in the surfaces of the individual layers, resulting in a situation where the difference in level exceeds the depth of focus in lithography. In order to avoid such a problem, high planarization techniques are important in the process of forming multilayered wirings.

As the material for such wirings, copper has been recognized because of its low resistivity as compared with conventional aluminum alloys and also because of its excellence in electromigration resistance. Since the vapor pressure of copper chloride gas is low, it is difficult to form copper into the shape of wirings by Reactive Ion Etching (RIE) which has been commonly used. Therefore, in order to form the wirings, a Damascene method is used.

This is a method such that concave portions such as trench patterns and via holes, are formed in an insulating layer. A conductive barrier layer is then formed thereon, and then copper is deposited to form a film by sputtering, plating, or the like so as to be embedded in the trench portions. Then, excess copper and conductive barrier layer are removed by Chemical Mechanical Polishing method (Chemical Mechanical Polishing, hereinafter referred to as "CMP") until the surface of the insulating layer is exposed, other than the portions corresponding to the concave portions, whereby the surface is planarized and embedded metal wirings are formed. Recently, a Dual Damascene method (Dual Damascene) has been predominantly used, in which copper wirings having copper embedded in concave portions and via holes are simultaneously formed.

On the other hand, in ULSI (Ultra-Large Scale Integration), a multi-level connection technology using techniques for horizontal connection called lines and perpendicular connection called contacts (connection to substrates) or via holes (connection between each layer wirings), has been developed.

In recent years, in order to meet the demand for high speed of integrated circuits, attention has been drawn to a combination of a wiring material having a low resistivity and an insulating layer material having a low relative dielectric constant. The demand for lowering the relative dielectric constant has extended even to an insulating barrier layer, an etching stopper layer, an antireflection layer, etc. However, the representative material, SiNₓ, which has been used for constituting the insulating barrier layer, the etching stopper layer, the antireflection layer, etc., has a large relative dielectric constant of about 7. Therefore, it is not desirable to use such SiNₓ since it is against the demand for lowering the relative dielectric constant of the entire insulating layers of an integrated circuit. On the other hand, with respect to SiC, a material having a relative dielectric constant of about 4 is known which has been developed by improving its production process, and it is capable of fulfilling the demand for lowering the relative dielectric constant.

Therefore, also in the process for producing semiconductor integrated circuits based on the Dual Damascene method, cases have been studied wherein SiC having a low relative dielectric constant is used for the etching stopper layer, the insulating barrier layer, the antireflection layer, etc. (for example, Patent Document 1). Thus, SiC is becoming increasingly important as an essential material which is necessary for many layers in one ULSI structure.

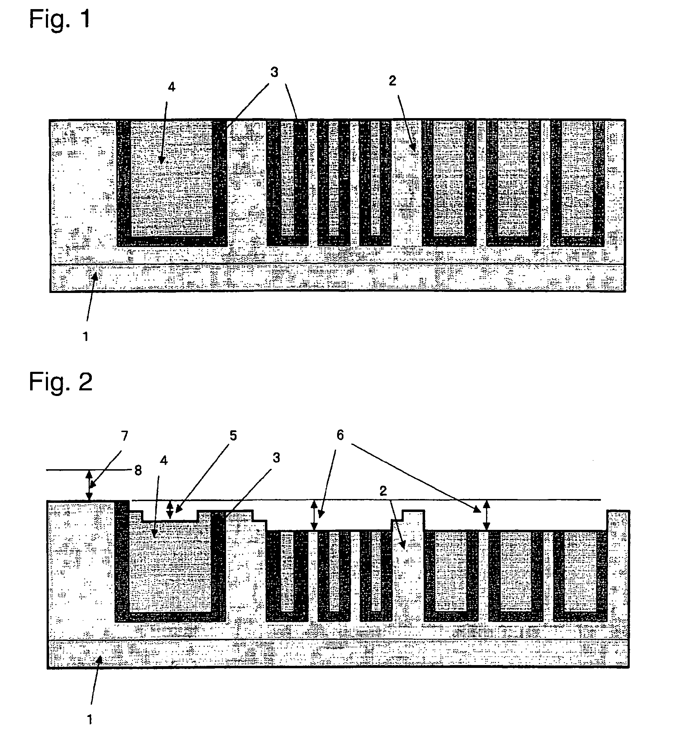

In a case where simultaneously forming via hole portions and copper wirings wherein copper embedded in concave portions of a substrate by the Dual Damascene method, two steps of polishing are usually necessary. In the 1st polishing step, an excess portion of a metal wiring layer is removed. Then, in the 2nd polishing step, an excess portion of a conductive barrier layer is removed. Here, for the conductive barrier layer, tantalum or tantalum nitride is usually used. Fig. 1 shows an ideal situation having lines formed with different wiring widths and wiring density after polishing, wherein the conductive barrier layer 3 and metal wiring layer 4, are embedded in the insulating layer 2 formed on the Si substrate 1.

In such planarization, when CMP is carried out by actually using the polishing compound, dishing or erosion may result in copper-embedded wirings, and a flat surface may not necessarily be obtained. An actual cross-sectional configuration is shown in Fig. 2. Here, dishing 5 means such a state that the metal wiring layer 4 is over-polished so that the central part thereof is concaved, and it is likely to occur at a wide wiring portion. Erosion is likely to occur at a portion where wirings are dense and the insulating layer has a narrow width, and it means such a phenomenon that the insulating layer 2 in the wiring portion is over-polished as compared with the insulating layer portion (Global portion) having no wiring pattern and the insulating layer 2 becomes partly thin. Namely, it means that erosion 6 will be formed as polished more than the polished portion 7 of the Global portion. Further, number 8 shows a standard surface before polishing.

If lamination is continued while flatness is not secured because of such dishing or erosion, as wirings are multilayered, the degree of unevenness tends to increase on the surfaces of the individual layers, resulting in a problem such that the difference in level exceeds the depth of focus in lithography. In order to avoid such a problem, a high planarization technique is important in the process of forming multilayered wirings.

Such a high planarization technique may, for example, be a method wherein an excess conductive barrier layer is removed at a high removal rate in the 2nd polishing step, and then, while an exposed insulating layer is scraped off, a metal wiring layer is polished at the same time and at a proper removal rate, to accomplish a high level of planarization. However, if it is attempted to eliminate the big difference in level solely by scraping off the insulating layer in the 2nd polishing step, the amount of the insulating layer to be scraped off will become large, and the amount of the copper wiring to be scraped off at the same time will also become large. This means a substantial weight loss of wirings and results in an increase of the resistance of wirings.

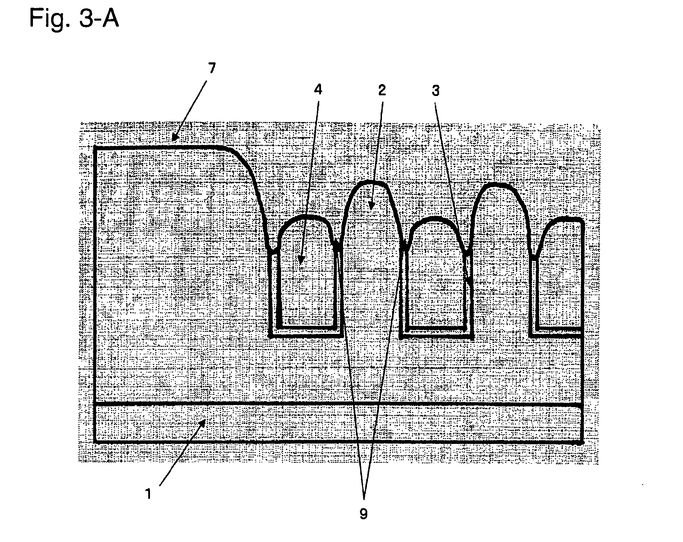

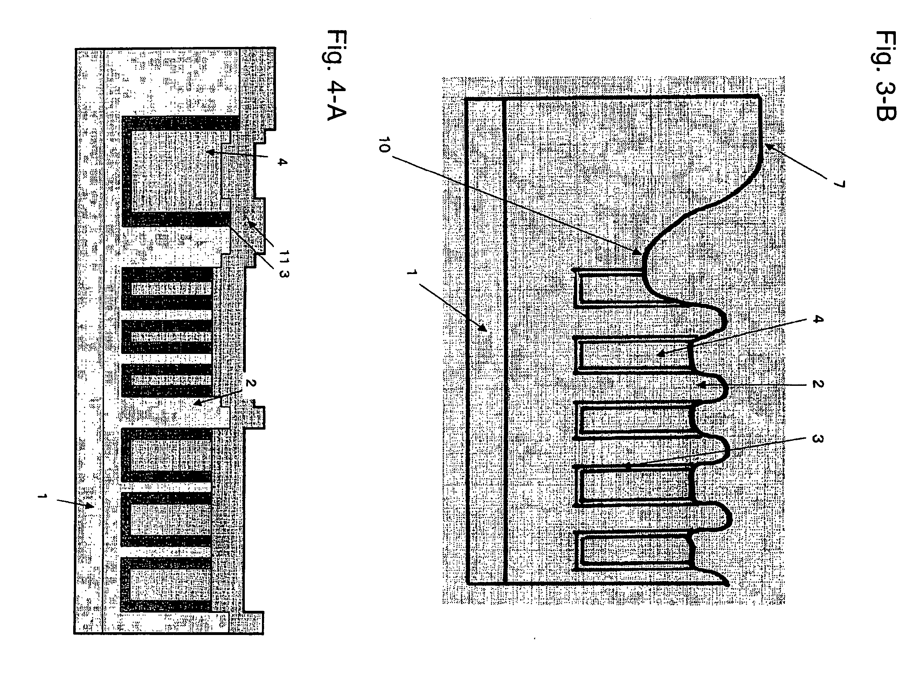

Further, by a study of cross-sectional unevenness of the surface to be polished by a profilometer, it became clear that in the 2nd step, the conductive barrier layer designed as one having the highest removal rate is also simultaneously scraped off, whereby the conductive barrier layer on the side of a wiring portion is over-polished, and flatness will be substantially deteriorated, as shown in Fig. 3-A number 9. Further, as Fig. 3-B shows at number 10, it became clear that an insulating layer of the global portion close to an end of wirings becomes over-polished, and flatness will be partly deteriorated.

To solve the problem, in recent years, it has been proposed that the amount to be scraped in the 2nd polishing step is stopped at a proper point, then an insulating barrier layer made of SiC is formed as the top layer, and this insulating barrier layer is polished to attain a high level of planarization. However, SiC is a material which has a high degree of hardness, and it is extremely difficult to form a highly planarized surface by polishing. Further, there is a problem such that scratches are likely to be formed on the SiC layer surface by SiC fragments detached by polishing (for example, Patent Document 2). Thus, a case study on a method of polishing a SiC layer by CMP is extremely rare.

For example, in Patent Document 2, a method is proposed such that after polishing a SiC monitor wafer by using diamond abrasive particles, polishing is carried out by a polishing compound which has a pH of 10 or 11 and contains a colloidal silica (particle size of 70 nm) and a basic compound, for planarization. It is disclosed that in this method, a rate of etching is low, and this indicates that mechanical polishing is major rather than chemical polishing, whereby there was a problem such that scratches are likely to be easily formed.

Further, in Patent Document 3, it is disclosed that in production of a SiC wafer, polishing is carried out by a polishing liquid comprising hard abrasive particles having an average particle size of from 0.1 to 5 µm, organosilane or silicone oil which is to be a dispersant for aggregated abrasive particles, and a solvent. However, when this technique was used for polishing the SiC layer for LSI having high-density fine wirings formed, there was a problem such that scratches were likely to be easily formed. Further, in the technique disclosed in Patent Document 3, it was difficult to use, as abrasive particles, colloidal silica which is advantageous for suppressing scratches and has a small average particle size. Further, the technique was not sufficient also from a viewpoint of stability of the dispersion.

Further, in any one of above methods, when SiC and silicon dioxide having a lower degree of hardness than SiC are simultaneously polished, polishing of silicon dioxide preferentially proceeds. Therefore, the above methods could not be employed when it is desired to polish e.g. an insulating barrier layer, an etching stopper layer or an antireflection layer, made of SiC, at a high removal rate and to suppress polishing of an insulating layer made of silicon dioxide.
Patent Document 1: JP-A-2002-526916
Patent Document 2: JP-A-2003-249426
Patent Document 3: JP-A-2001-326200

### DISCLOSURE OF THE INVENTION

### OBJECTS TO BE ACCOMPLISHED BY THE INVENTION

It is an object of the present invention to realize a flat surface of an insulating layer having embedded metal wirings, in polishing a surface to be polished in the production of a semiconductor integrated circuit device. More specifically, the present invention is to provide a polishing compound for chemical mechanical polishing useful for polishing SiC which is a constituting material of e.g. an insulating barrier layer, an etching stopper layer or an antireflection layer, at a high removal rate, or for suppressing polishing of silicon dioxide in the insulating layer on the other hand while polishing SiC at a high removal rate; a method for polishing the surface to be polished by using the polishing compound; and a method for producing a semiconductor integrated circuit device. Other objects and merits of the present invention will be apparent from the following description.

### MEANS TO ACCOMPLISH THE OBJECTS

The present invention provides the following.
1. A polishing compound which is a polishing compound for chemical mechanical polishing to polish a SiC-containing surface to be polished in production of a semiconductor integrated circuit device, and which comprises abrasive particles (A); at least one removal rate-adjusting agent (B) selected from the group consisting of a benzotriazole, a 1H-tetrazole, a benzene sulfonic acid, phosphoric acid or an organic phosphonic acid, an organic solvent (C) having a relative dielectric constant of from 15 to 80, a boiling point of from 60 to 250°C and a viscosity of from 0.5 to 60 mPa·s at 25°C; and water (D).
2. The polishing compound according to the above 1, which further contains a basic compound (E) and has a pH within a range of from 9 to 12.
3. The polishing compound according to the above 1 or 2, which further contains an inorganic acid (F) and a pH buffer (G).
4. The polishing compound according to any one of the above 1 to 3, which is used for polishing the surface to be polished which further contains silicon dioxide.
5. The polishing compound according to any one of the above 1 to 4, wherein the removal rate selectivity of SiC layer/silicon dioxide layer is at least 3.
6. The polishing compound according to any one of the above 1 to 5, the above abrasive particles (A) are colloidal silica.
7. The polishing compound according to any one of the above 1 to 6, which comprises 0.1 to 20 mass% of the abrasive gains (A), 0.001 to 50 mass% of the removal rate- adjusting agent (B), 0.1 to 20 mass% of the organic solvent (C) and 40 to 98 mass% of water (D), based on 100 mass% of the total mass of the above polishing compound.
8. The polishing compound according to any one of the above 1 to 7, wherein the above abrasive particles (A) have an average primary particle size in a range of from 5 to 300 nm.
9. The polishing compound according to any one of the above 1 to 8, which further contains at least one additive (H) selected from the group consisting of polyacrylic acid, pullulan, glycylglycine and N-benzoylglycine.
10. A method for polishing a surface to be polished, which comprises supplying a polishing compound to a polishing pad, and bringing a surface to be polished of a semiconductor integrated circuit device and the polishing pad into contact with each other to polish the surface to be polished by relative movement between them, wherein the surface to be polished is a SiC-containing surface to be polished, and the polishing compound as defined in any one of the above 1 to 9 is used as the polishing compound.
11. A method for producing a semiconductor integrated circuit device, which comprises a step of polishing a surface to be polished by the polishing method as defined in the above 10.

### EFFECTS OF THE INVENTION

According to the present invention, it is possible to polish SiC at a high removal rate in a process for producing a semiconductor integrated circuit device. In addition, it is possible to suppress polishing of silicon dioxide in the insulating layer on the other hand, while polishing SiC at a high removal rate.

Further, it is possible to obtain a semiconductor integrated circuit device having planarized multiplayer structure.

### BRIEF DESCRIPTION OF THE DRAWINGS

Fig. 1 is a schematic cross-sectional view of a wiring structure which shows a state in which a conductive barrier layer and a metal wiring layer are embedded in an insulating layer.
Fig. 2 is a schematic cross-sectional view of a wiring structure to illustrate dishing and erosion of embedded wirings.
Fig. 3-A is a representative schematic view showing the result of measurement of the profile by a profilometer to illustrate deterioration of the flatness of the surface polished.
Fig. 3-B is another representative schematic view showing the result of measurement of the profile by a profilometer to illustrate deterioration of the flatness of the surface polished.
Fig. 4-A is a schematic cross-sectional view showing a wiring structure to illustrate how a surface to be polished, which contains an insulating barrier layer made of SiC, is planarized.
Fig. 4-B is another schematic cross-sectional view showing a wiring structure to illustrate how a surface to be polished, which contains an insulating barrier layer made of SiC, is planarized.

### MEANINGS OF SYMBOLS

1: Si substrate
2: Insulating layer
3: Conductive barrier layer
4: Metal wiring layer
5: Dishing
6: Erosion
7: Polished portion of a global portion
8: Standard surface before polishing
9: Excessive scraping of conductive barrier layer
10: Excess scraping of insulating layer of the global portion
11: Insulating barrier layer
12: Insulating layer of the global portion

### BEST MODE FOR CARRYING OUT THE INVENTION

Now, embodiments of the present invention will be described with reference to the drawings, Tables, Formulae, Examples, etc. Such drawings, Tables, Formulae, Examples, etc. and the description are to exemplify the present invention and by no means restrict the scope of the present invention. Other embodiments may also belong to the scope of the present invention so long as they meet the concept of the present invention. In the drawings, the same symbol designates the same element.

Heretofore, as disclosed in Patent Document 2 and 3, polishing was extremely difficult, and in order to increase the grinding force, it was necessary to use hard diamond, and it was found that SiC polishing which needed acceleration of the mechanical grinding force, was effectively carried out by a combined effect of a chemical function and a mechanical function.

That is, the polishing compound of the present invention is a polishing compound for chemical mechanical polishing to polish a SiC-containing surface to be polished in production of a semiconductor integrated circuit device, which polishing compound comprises abrasive particles (A); at least one removal rate-adjusting agent (B) selected from the group consisting of a benzotriazole, a 1H-tetrazole, a benzene sulfonic acid, phosphoric acid or an organic phosphonic acid, an organic solvent (C) having a relative dielectric constant of from 15 to 80, a boiling point of from 60 to 250°C and a viscosity of from 0.5 to 60 mPa·s at 25°C; and water (D). The polishing compound according to the present invention, is in the form of slurry.

When such a polishing compound is used, it is possible to polish a portion made of SiC at a high removal rate in polishing a surface to be polished in a process for producing a semiconductor integrated circuit device. Therefore, it is particularly preferred to use it for polishing a SiC-made insulating barrier layer 11 having unevenness caused by an uneven profile of the lower wirings.

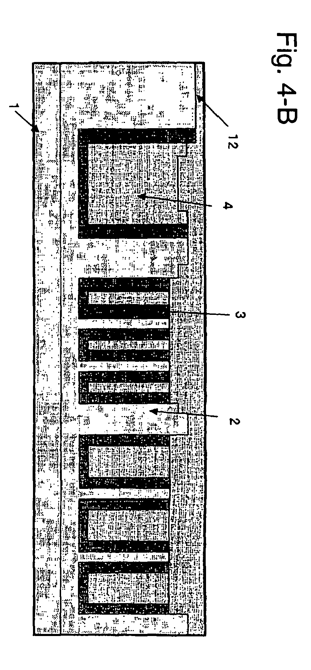

Fig. 4-B shows an ideal cross-sectional view of wirings planarized by this polishing compound. From Fig. 4-A and Fig. 4-B, it is understood that even if unevenness was remained after carrying out the step (the 2nd polishing step) of removing an excess portion of a conductive barrier layer, it is possible to obtain a flat surface by using the polishing compound of the present invention for polishing the SiC-made insulating barrier layer formed thereon. Further, it is needless to say that the polishing compound of the present invention is suitably useful also for the SiC-made etching stopper layer and an antireflection layer.

Further, it is particularly suitable for polishing a SiC layer at a high removal rate and suppressing polishing of the insulating layer made of e.g. silicon dioxide as the lower layer. As shown in Fig. 4-A and Fig. 4-B, the insulating layer may be frequently disposed right beneath the SiC layer, and its surface may be sometimes exposed to the surface to be polished, as polishing proceeds. Silicon dioxide is often used as a material to form the insulating layer. When the surface to be polished contains SiC and silicon dioxide, a removal rate of silicon dioxide becomes substantially high, and with a conventional polishing compound, it was difficult to overcome the problem of difference in level between a surface to be polished made of SiC and a surface to be polished made of silicon dioxide. The polishing compound according to the present invention is capable of suppressing the removal rate on silicon dioxide as compared to the removal rate of SiC, so that it is possible to achieve a high level of flatness when the surface to be polished contains SiC and silicon dioxide.

Further, it has been found that with the composition of the above polishing compound, it is possible to decrease scratches on the insulating layer made of e.g. SiC or silicon dioxide, while gaining the above effects. Therefore, it becomes easy to produce an integrated circuit having high reliability and excellence in electric characteristics. Further, by the high removal rate of the insulating layer made of e.g. SiC or silicon dioxide, it is possible to shorten the polishing time and reduce the amount of polishing compound, whereby the cost will be remarkably reduced. Further, the polishing compound of the present invention is generally excellent in dispersion stability of abrasive particles.

In addition, a "surface to be polished" in the present invention means an intermediate stage surface appearing in the process for producing a semiconductor integrated circuit device. In the present invention, a SiC layer is the object to be polished. Therefore, at least at a part of the "surface to be polished" of the present invention, a SiC layer exists as e.g. an etching stopper layer, an insulating barrier layer or an antireflection layer. The "surface to be polished containing SiC" thus means that, SiC is exposed at least at a part of the "surface to be polished." Further, the "surface to be polished further containing silicon dioxide" means that a surface of an insulating layer made of e.g. silicon dioxide is exposed at least at a part of the "surface to be polished" together with SiC.

Here, the barrier layer means a diffusion-preventing layer provided to prevent a short-circuiting to be caused by diffusion of copper of a wiring metal into a silicon dioxide or low dielectric constant insulating layer. However, a barrier layer provided at in a place where electrical conduction is unnecessary is called an insulating barrier layer, and one provided at a place where electrical conduction is necessary is called a conductive barrier layer. The representative insulating barrier layer is SiC or SiNₓ, as mentioned above, and also known is one containing a methyl group or oxygen as a part of its structure to decrease the relative dielectric constant. On the other hand, the representative conductive barrier layer is tantalum or tantalum nitride, as mentioned above.

The insulating barrier layer containing SiC has characteristics such that it can effectively prevent diffusion of copper during annealing at 450°C, it has excellent adherence, and it has excellent electrically insulating characteristics.

The etching stopper layer is a layer to prevent etching to extend below the insulating layer when a concave portion for an embedded wiring is formed by the etching. Therefore, the etching stopper layer needs to have an etching speed slower than an insulating layer which is usually a layer to be etched. The etching stopper layer made of SiC has characteristics such as high etching selectivity for an insulating layer, and a low relative dielectric constant.

The abrasive particles (A) in the polishing compound of the present invention may optionally be selected from known abrasive particles. Specifically, they are preferably at least one type selected from the group consisting of silica, alumina, cerium oxide (ceria), zirconium oxide (zirconia), titanium oxide (titania), tin oxide, zinc oxide and manganese oxide.

As silica, it is possible to use one made by a wide variety of known methods. For example, colloidal silica may be mentioned which is obtained by hydrolysis of a silicon alkoxide compound such as ethyl silicate or methyl silicate by a sol-gel method. Further, fumed silica may be mentioned which is synthesized in a vapor-phase by reacting silicon tetrachloride and colloidal silica made by ion exchange of sodium silicate, in the flame of oxygen and hydrogen.

Also colloidal alumina is preferably used. Further, cerium oxide, zirconium oxide, titanium oxide, tin oxide or zinc oxide, which is formed by a liquid-phase method or a vapor-phase method, is also preferably used. Among them, colloidal silica is preferred because particle size can easily be controlled and a highly purified product can be obtained.

From viewpoints of polishing characteristics and dispersion stability, the average primary particle size of abrasive particles (A) is, preferably in a range of from 5 to 300 nm, particularly preferably from 10 to 100 nm. Further, the average secondary particle size of abrasive particles (A) in the polishing compound of the present invention is preferably in a range of from 8 to 500 nm, particularly preferably from 20 to 200 nm.

The average particle size of abrasive particles (A) may be measured by a known method. For example, the average primary particle size may be obtained as a particle size of equivalent spheres from the measured value of the specific surface area of particles obtained by drying the aqueous dispersion. Here, the specific area of the particles may be measured by using FlowSorb II 2300 Model manufactured by Shimadzu Corporation.

The average secondary particle size in the polishing compound of the present invention is the average diameter of aggregates in the polishing compound. For measurement of the average secondary particle size in the polishing compound of the present invention, a method using a particle size distribution meter of dynamic light scattering system such as MICROTRAC UPA manufactured by NIKKISO CO., LTD., may be used.

The concentration of abrasive particles (A) in the polishing compound of the present invention is, in consideration of the removal rate, uniformity in the removal rate over the wafer surface and dispersion stability, preferably adjusted in the range of from 0.1 to 20 mass%, based on 100 mass% of the total mass of the polishing compound. The concentration is preferably in the range of from 1 to 15 mass% of the total mass of the polishing compound. If the concentration of abrasive particles (A) in the polishing compound of the present invention is too low, the polishing effect is reduced. If the concentration is too high, abrasive particles are likely to aggregate.

The present inventors have conducted extensive studies, and as a result, they have found that when at least one removal rate-adjusting agent (B) selected from the group consisting of a benzotriazole, a 1H-tetrazole, a benzene sulfonic acid, phosphoric acid and an organic phosphonic acid, is added to the polishing compound to form a polishing composition, the removal rate of SiC is improved. The reason for the improvement of the removal rate of SiC by adding the removal rate-adjusting agent (B) is not apparent; however, it is considered that a nitrogen-containing heterocyclic moiety, a sulfonic acid moiety or a hydroxyl group-bonded phosphorus atom moiety in the removal rate-adjusting agent (B), and carbon atoms or a Si-C bonding present in the surface to be polished, undergo some kind of chemical interaction.

In the present invention, a benzotriazole includes benzotriazole and a benzotriazole derivative wherein a hydrogen atom bonded to a carbon atom and/or a nitrogen atom of benzotriazole is substituted by a monovalent substituent group such as a monovalent atom e.g. a halogen atom, a monovalent functional group e.g. a hydroxyl group, a carboxyl group or an amine group, or a monovalent organic group e.g. an alkyl group or an alkoxyl group. The benzotriazole is preferably the compound shown by the following formula (1).

In the present invention, a 1H-tetrazole includes 1H-tetrazole and a 1H-tetrazole derivative wherein a hydrogen atom bonded to a carbon atom and/or a nitrogen atom of 1H-tetrazole is substituted by a monovalent substituent group such as a monovalent atom e.g. a halogen atom, a monovalent functional group e.g. a hydroxyl group, a carboxyl group or an amine group, or a monovalent organic group e.g. an alkyl group or an alkoxyl group. The 1H-tetrazole is preferably the compound shown by the following formula (2).

In the present invention, a benzene sulfonic acid includes benzene sulfonic acid and a benzene sulfonic acid derivative wherein a hydrogen atom bonded to a carbon atom and/or a nitrogen atom of benzene sulfonic acid is substituted by a monovalent substituent group such as a monovalent atom e.g. a halogen atom, a monovalent functional group e.g. a hydroxyl group, a carboxyl group or an amine group, or a monovalent organic group e.g. an alkyl group or an alkoxyl group. The benzene sulfonic acid is preferably the compound shown by the following formula (3).

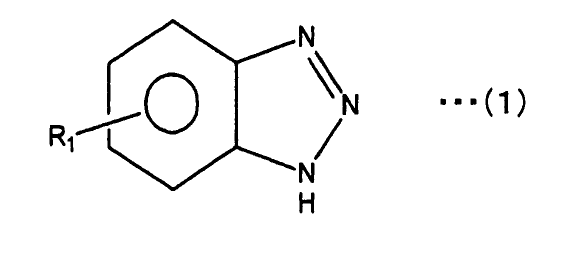

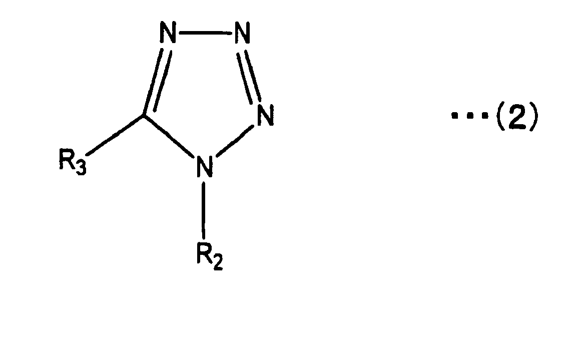

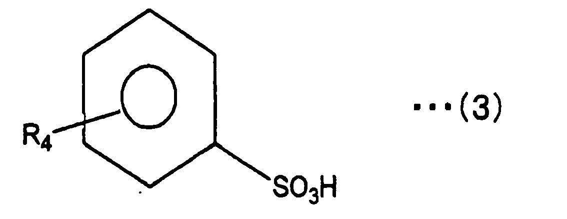

Here, in the formula (1), R₁ is a hydrogen atom, a C₁₋₄ alkyl group, a C₁₋₄ alkoxyl group or a carboxyl group. In the formula (2), each of R₂ and R₃ which are independent of each other, is a hydrogen atom, a C₁₋₄ alkyl group, a C₁₋₄ alkoxyl group, a carboxyl group or an amine group. In the formula (3), R₄ is a C₁₋₄ alkyl group or a C₁₋₄ alkoxyl group. Further, when an acidic material or a basic material is present in the polishing compound of the present invention, one in the form of salt may be included in the removal rate-adjusting agent (B).

The specific compound shown by the formula (1) may, for example, be benzotriazole (hereinafter referred to as BTA), a tolyltriazole (hereinafter referred to as TTA) having one of hydrogen atoms at 4- or 5- positions of a benzene ring of BTA substituted by a methyl group, or a benzotriazole-4-carboxylic acid having such a hydrogen atom substituted by a carboxyl group. The compound shown by the formula (2) may, for example, be 1H-tetrazole, 5-amino-1H-tetrazole (hereinafter referred to as HAT) or 5-methyl 1H-tetrazole. The specific compound shown in the formula (3) may, for example, be p-toluene sulfonic acid (hereinafter referred to as PTS) having a hydrogen atom at p-position substituted by a methyl group.

Further, a material such as diphosphorus pentaoxide which forms phosphoric acid by hydrolysis, may also be used as the removal rate-adjusting agent (B).

Further, an organic phosphonic acid is an organic compound wherein -P(=O)(OH)₂ is bonded to a carbon atom of an organic group, and it is preferably a compound represented by R₅-(-P(=O) (OH)₂)ₙ. Here, R₅ is a n-valent organic group, and n is an integer of from 1 to 8 (preferably from 1 to 6).

Here, R₅ is more preferably a C₁₋₂₀ (preferably from C₂₋₁₀) organic group, and n is more preferably an integer of from 1 to 4. R₅ may contain a halogen atom, an oxygen atom, a nitrogen atom or other atoms other than hydrogen atoms. Especially, R₅ preferably to contains at least one member selected from the group consisting of a tertiary amino group, a carboxyl group and a hydroxyl group. It may, for example, be specifically, 2-phosphonobutane-1,2,4-tricarboxylic acid (hereinafter referred to as PH1), 1-hydroxyl ethylidene-1,1-diphosphonic acid (hereinafter referred to as PH2), nitrilotris (methyl phosphonic acid) (hereinafter referred to as PH3) or N,N,N'N'-tetrakis (phosphonomethyl) ethylene diamine (hereinafter referred to as PH4). Such phosphonic acids may be used alone or in combination as a mixture of two or more of them.

With a view to accelerating polishing of SiC sufficiently, the concentration of the removal rate-adjusting agent (B) in the polishing compound of the present invention is, in consideration of such as the removal rate, preferably adjusted in the range of from 0.01 to 50 mass% based on the total mass of the polishing compound being 100 mass%. It is more preferably in the range of from 0.2 to 10 mass% based on the total mass of the polishing compound. If the concentration of the removal rate-adjusting agent (B) in the polishing compound of the present invention is too low, the effect for improving the removal rate is not sufficiently exhibited in many cases. If the concentration is higher than a certain level, the effect for improving the removal rate is saturated, so that too high concentration is not economical.

In the polishing compound of the present invention, an organic solvent (C) having a relative dielectric constant of from 15 to 80, a boiling point of from 60 to 250°C and a viscosity of from 0.5 to 60 mPa·s at 25°C is further contained in addition to the abrasive particles (A) and the removal rate-adjusting agent (B). The organic solvent (C) is added to adjust the fluidity or the dispersion stability of the polishing compound.

As the organic solvent (C), one having a relative dielectric constant of from 15 to 80, a boiling point of from 60 to 250°C and a viscosity of from 0.5 to 5 mPa·s at 25°C, is particularly preferred.

As the organic solvent (C), it is preferred to use at least one organic solvent selected from a group consisting of a C₁₋₄ primary alcohol, a C₂₋₄ glycol, an ether represented by CH₃CH(OH)CH₂O-CₘH₂ₘ₊₁ (wherein m is an integer of from 1 to 4), N-methyl-2-pyrrolidone, N,N-dimethyl formamide, dimethylsulfoxide, γ-butyllactone and carbonic propylene.

Specifically, as the primary alcohol, methyl alcohol, ethyl alcohol or isopropyl alcohol (hereinafter referred to as IPA) is preferred. As the glycol, ethylene glycol (hereinafter referred to as EG) or propylene glycol is preferred. As the ether, propylene glycol monomethyl ether (hereinafter referred to as PGM) or propylene glycol monoethyl ether (hereinafter referred to as PGE) is preferred. Further, N-methyl-2-pyrrolidone, N,N-dimethyl formamide, dimethyl sulfoxide, γ-butyllactone or carbonic propylene is preferred, because it is a polar solvent having a relative dielectric constant in a range of from 30 to 65 at 25°C, and it is capable of dissolving the electrolyte at a high concentration by solvation.

With a view to adjusting the fluidity, the dispersion stability and the removal rate of the polishing compound, the concentration of the organic solvent (C) in the polishing compound of the present invention is, preferably in a range of from 0.1 to 20 mass%, particularly preferably from 0.5 to 10 mass%, based on the total mass of the polishing compound being 100 mass%. If the concentration of the organic solvent (C) in the polishing compound of the present invention is too low, the above effect is not sufficiently exhibited in many cases. If the concentration is higher than a certain level, the effect for improving the removal rate is saturated, so that too high concentration is not economical.

In the polishing compound in the present invention, water (D) is used in order to have abrasive particles dispersed stably.

As the water to be used, any type may be used as long as it is not against the purpose of the present invention. However, it is preferred to use e.g. purified water or deionized water. Water (D) is preferably contained in a range of from 40 to 98 mass%, particularly preferably from 50 to 90 mass%, based on the total mass of the polishing compound being 100 mass%. Since the polishing compound of the present invention contains water (D) having a high surface tension, addition of the above organic solvent (C) is useful for adjusting its fluidity.

In order to adjust the polishing compound of the present invention to the prescribed pH, it is preferred to add a basic compound (E) to the polishing compound. As the basic compound (E), ammonia, potassium hydroxide, a quaternary ammonium hydroxide such as tetramethyl ammonium hydroxide or tetraethyl ammonium hydroxide, or monoethanol amine, may be used. Among them, potassium hydroxide is preferred because a highly purified product can be easily obtained, and its price is low.

The concentration of the basic compound (E) in the polishing compound of the present invention is, preferably in a range of from 0.01 to 50 mass%, more preferably in a range of from 0.01 to 20 mass%, based on the total mass of the polishing compound being 100 mass%.

Here, the pH of the polishing compound of the present invention may be properly adjusted in consideration of the dispersion stability and the desired removal rate, and the pH is preferably in a range of from 9 to 12, particularly preferably in a range of from 10 to 12, so that it is possible to increase the removal rate of SiC. If the pH of the polishing compound of the present invention is too low, the removal rate of silicon dioxide becomes high, and if the pH is too high, the concentration of alkali in the polishing compound becomes high, whereby the dispersion stability is deteriorated.

Further, in order to adjust the polishing compound of the present invention to have a prescribed pH, it is preferred to add an inorganic acid (F) to the polishing compound. As such an inorganic acid (F), at least one inorganic acid selected from a group consisting of nitric acid, acetic acid or hydrochloric acid, is mentioned. Among them, preferred is nitric acid which is an oxoacid having oxidizing power and contains no halogen. Further, the concentration of the inorganic acid (F) is preferably in a range of from 0.005 to 5 mass%, based on the total mass of the polishing compound being 100 mass%. It is more preferably in a range of from 0.01 to 1 mass%. By the addition of the inorganic acid (F), it is possible to increase the removal rate of e.g. an insulating barrier layer, an etching stopper layer or an antireflection layer made of SiC. Further, the components contained in the removal rate-adjusting agent (B) are not regarded as the above basic compound (E) and inorganic acid (F).

The basic compound (E) and the inorganic acid (F) may be added at any stage to the polishing compound of the present invention. For example, a case where those having components corresponding to (A) to (C) treated with an acid or a basic compound, are used as components of the polishing compound, also corresponds to an addition of the above-described acid or basic compound. Further, all or part of the basic compound (E) and the inorganic acid (F) to be used, may be reacted to form a salt and then added. However, in the present invention, it is preferred to separately add the basic compound (E) and the inorganic acid (F) from such a viewpoint that the pH of the polishing compound can easily be adjusted to be in a desired range and from the viewpoint of handling efficiency. Further, the concentrations of the basic compound (E) and the inorganic acid (F) in the form of a salt in the polishing compound mean concentrations when it is assumed that the salt is present as an acid and a basic compound which are independent of each other.

In a case where the abrasive particles (A) are alumia or ceria, in consideration of their isoelectric points or gelation range, the pH is adjusted to the optimum value. For this purpose, a pH buffer (G) may be used. As the pH buffer (G), any one may be used as long as it is a substance having a general pH-buffering ability. For example, it is preferably one member selected from polyvalent carboxylic acids such as succinic acid, citric acid, oxalic acid, phthalic acid, tartaric acid and adipic acid. The concentration of the pH buffer (G) in the polishing compound of the present invention is preferably from 0.01 to 10 mass%, particularly preferably from 0.05 to 2 mass%, based on the total mass of the polishing compound being 100 mass%. The pH buffer (G) i.e. a substance having a pH-buffering ability, is not regarded as the above inorganic acid (F) or basic compound (E).

To the polishing compound of the present invention, as an additive (H), it is possible to add at least one additive (H) selected from the group consisting of polyacrylic acid (hereinafter referred to as PA), pullulan, glycylglycine (hereinafter referred to as GG) and N-benzoylglycine (hereinafter referred to as BG), such being suitable in many cases. The reason is not necessarily apparent, but it is considered such that since such a substance has a hydrophilic group (a hydroxyl group, an amine group or a carboxylic group), when incorporated to a polishing compound, it is stably present in the polishing compound and impart suitable lubricity and viscosity for SiC polishing. Here, the amount of the additive (H) added is preferably in a range of from 0.01 to 50 mass%, particularly preferably from 0.05 to 2 mass%, based on the total mass of the polishing compound being 100 mass%. Further, even though GG has the pH-buffering ability, it is not regarded as the above pH buffer (G) in the present invention.

To the polishing compound of the present invention, an oxidizing agent, a surfactant, a chelating agent, a reducing agent, a viscosity-imparting agent or viscosity-controlling agent, an agglomeration-preventing agent or dispersant, an anticorrosive, etc. may suitably be incorporated, as the case requires, unless such incorporation is against the purpose of the present invention. When adding the oxidizing agent, it is preferred to use at least one member selected from a group consisting of hydrogen peroxide, an iodate, a periodate, a hydrochlorite, a perchlorite, a persulfate, a percarbonate, a perborate and a superphosphate. Among them, preferred is hydrogen peroxide which has no alkaline metal component, and forms no harmful byproduct.

Further, the polishing compound of the present invention is not necessarily supplied for the polishing in such a form that all of the constituting polishing materials is preliminarily mixed. At the time of supply for the polishing, the polishing materials may be mixed to constitute the composition of the polishing compound.

As SiC which is the material for forming the polishing object such as the insulating barrier layer, the etching stopper layer or the antireflection layer, to be polished by the polishing compound of the present invention, any known one may be used. In SiC, multiple components coexist in many cases, as mentioned later. For the polishing compound of the present invention, it is not critical how much amounts of other components coexist, as long as their effects are exhibited.

Particularly, the SiC film (tradename: BLOk) invented by APPLIED MATERIALS, INC. in Santa Clara, California in the United States of America, is a suitable material because it has a relative dielectric constant k of 4.2, and a refractive index n of 1.9 at an exposure wavelength of 633 nm. That is, as compared with SiNx which is known as a constituent material for an insulating barrier layer, and which has a relative dielectric constant k of 7.0, it is understood that the SiC film contributes to lowering the conductivity of the entire integrated circuit, and at the same time, it has sufficient optical characteristics also as an antireflection layer.

The details about this SiC film (tradename: BLOk) are disclosed in Patent Document 1. The SiC film (tradename: BLOk) which is formed by using an organic silane type compound such as methyl silane or trimethyl silane, as a silicon source and a carbon source, transferring it to a chamber by a noble gas such as helium or argon, and reacting it by RF plasma inside the chamber, is a film containing a bonding structure made of CH₂/CH₃, SiH, Si-CH₃, Si-(CH₂)ₙ and SiC, as analyzed by a Fourier transform infrared spectroscopy (FTIR).

Further, in the present invention, the removal rate selective ratio of the SiC layer to the insulating layer, specifically, the removal rate selective ratio of the SiC layer/the silicon dioxide layer is preferably at most 3, more preferably at most 5. If this removal rate selective ratio is less than 3, it is difficult to eliminate the difference in level when the insulating layer (made of silicon dioxide) at a global portion is exposed. By increasing the removal rate ratio, it is possible to remove an excess insulating barrier layer while suppressing over-polishing of the insulating layer at a global portion, and as a result, it is possible to highly planarize the surface to be polished.

The polishing compound of the present invention may be used for a polishing method for polishing the surface to be polished containing SiC by supplying the polishing compound to a polishing pad, and bringing the polishing pad and a surface to be polished into contact with each other by relative movement between them. Polishing may be carried out by bringing a pad conditioner and the polishing pad into contact with each other to carry out conditioning of the surface of the polishing pad.

By the polishing compound of the present invention, it is possible to carry out polishing of a polishing surface containing SiC, for example, a surface of e.g. an insulating barrier layer, an etching stopper layer or an antireflection layer made of SiC, at a high removal rate. Further, it is thereby possible to easily obtain a semiconductor integrated circuit device having a highly planarized multilayer structure. For example, a trench pattern and a concave portion such as a via hole for wiring are formed in an insulating layer on a substrate, and then a conductive barrier layer is formed. Then, metal such as copper is formed by spattering or plating to be embedded into trenches portion, and the metal and the conductive barrier layer are removed by CMP until the surface of the insulating layer other than the concave portion is exposed. Moreover, the present invention may be suitably used for a method for forming a flat surface at the surface to be polished having the insulating barrier layer made of SiC formed.

The polishing compound of the present invention has a selectivity in the removal rate such that, when silicon dioxide is used as a constituting material for the insulating layer as the lower layer of the SiC layer, its removal rate is remarkably suppressed, and it has a characteristic such that it is capable of highly planarizing the surface of the insulating layer as an upper layer of the embedded wiring layer. Such a characteristic is, in CMP technique, considered to be obtained by a combination of a chemical polishing attributable to the chemical composition of the polishing compound and mechanical polishing provided by abrasive particles, and it is the effect which has not been attained by conventional polishing compounds.

### EXAMPLES

Now, the present invention will be described in further detail with reference to Examples (Examples 1 to 16) and Comparative Examples (Examples 17 to 19).

### (1) Preparation of Polishing Compounds

(i) Each of polishing compounds of Examples 1 and 2 was prepared as follows. To water, the inorganic acid (F) and the pH buffer (G) were added, and the basic compound (E) in a half of the amount shown in Table 1 was further added, followed by stirring for 10 minutes to obtain liquid a. Then, the removal rate-adjusting agent (B) was dissolved in the organic solvent (C) to obtain liquid b having a solid content concentration of 40 mass%.
   Then, the liquid b and the aqueous dispersion of abrasive particles (A) were gradually added to the liquid a, and then, the rest of the basic compound (E) was gradually added to adjust the pH to the target level. Then, H₂O₂ was added, followed by stirring for 30 minutes to obtain a polishing compound. The components (A) to (G) used in respective Examples and the concentration (mass%) of H₂O₂ based on the total mass of the polishing compound are shown in Table 1 along with other property values. As the water, pure water was used. The concentration (mass%) of the water (D) based on the total mass of the polishing compound is calculated by 100-[the sum of concentrations of components (A) to (G) and H₂O₂].
(ii) Each of polishing compounds of Examples 3 and 4 was prepared as follows. To water, the inorganic acid (F), the removal rate-adjusting agent (B) (PTS) represented by the formula (3) and the pH buffer (G) were added, and the basic compound (E) in a half of the amount shown in Table 1 was further added, followed by stirring for 10 minutes to obtain liquid c. Then, the removal rate-adjusting agent (B) (BTA) represented by the formula (1) was dissolved in the organic solvent (C) to obtain liquid d.
   Then, the liquid d and the aqueous dispersion of abrasive particles (A) were gradually added to the liquid c, and then, the rest of the basic compound (E) was gradually added to adjust the pH to the target level. Then, H₂O₂ was added, followed by stirring for 30 minutes to obtain a polishing compound. Further, in Example 4, the additive (H) was added immediately before the aqueous dispersion of abrasive particles (A) was added. The components (A) to (G) used in respective Examples and the concentration (mass%) of H₂O₂ based on the total mass of the polishing compound are shown in Table 1 along with other property values. As the water, pure water was used. The concentration (mass%) of the water (D) based on the total mass of the polishing compound is calculated by 100-[the sum of concentrations of components (A) to (H) and H₂O₂].
(iii) Each of polishing compounds of Examples 5 to 19 was prepared as follows. To water, the inorganic acid (F), the removal rate-adjusting agent (B) and the pH buffer (G) were added, and the basic compound (E) in a half of the amount shown in Table 1 was further added, followed by stirring for 10 minutes to obtain liquid e.

Then, the aqueous dispersion of abrasive particles (A) was gradually added to the liquid e, and then, the rest of the basic compound (E) was gradually added to adjust the pH to the target level, followed by stirring for 30 minutes to obtain a polishing compound. Here, in Example 16, H₂O₂ was added immediately before stirring. Further, in Examples 5 to 16, the additive (H) was added immediately before the aqueous dispersion of abrasive particles (A) was added. The components (A) to (G) used in respective Examples and the concentration (mass%) of H₂O₂ based on the total mass of the polishing compound are shown in Table 1 along with other property values. As the water, pure water was used. The concentration (mass%) of the water (D) based on the total mass of the polishing compound is calculated by 100-[the sum of concentrations of components (A) to (H) and H₂O₂].

### (2) Measurements of Average Primary Particle Size of Abrasive Particles and Average Secondary Particle Size of Abrasive Particles in the Polishing Compound

The average primary particle size of abrasive particles was obtained as a particle size of equivalent spheres from the specific surface area of particles obtained by drying an aqueous dispersion. The specific surface area of particles was measured by a BET one point method being a nitrogen adsorption method by using FlowSorb II 2300 Model (manufactured by Shimadzu Corporation). As a result, the average primary particle size in each of Examples 1 to 19 was 17 nm.

Further, the average secondary particle size of the abrasive particles in the polishing compound was measured by a MICROTRAC UPA (manufactured by NIKKISO Co., Ltd.). As a result, in Example 1, the average secondary particle size of abrasive particles in the polishing compound was 27 nm; in Example 5, the average secondary particle size in the polishing compound was 24 nm; and in Examples 6 and 9, the average secondary particle sizes in the polishing compound were 26 nm.

### (3) Polishing Conditions

Polishing was carried out by the following apparatus and conditions.

Polishing machine: Full automatic CMP apparatus MIRRA (manufactured by Applied Materials, Inc.)
Polishing pressure: 14kPa
Rotational speed: Platen (polishing platen) 103 rpm, head (substrate-holding portion) 97 rpm
Polishing compound supply rate: 200 ml/min
Polishing pad: IC1400 (manufactured by Rodel, Inc.)

### (4) Objects to be Polished

The following Blanket wafers (a) to (d) were used.
(a) Wafer for evaluation of removal rate of SiC layer On an 8-inch Si wafer, a SiC layer having a thickness of 500 nm was formed by plasma CVD. This SiC layer is one for a simulation of polishing of e.g. an etching stopper layer, an insulating layer or an antireflection layer.
(b) Wafer for evaluation of removal rate of silicon dioxide

On an 8-inch Si wafer, a silicon dioxide layer having a thickness of 800 nm was formed by plasma CVD by using TEOS (tetra ethyl ortho-silicate). This silicon dioxide layer is one for simulation of polishing of an insulating layer made of silicon dioxide.

### (5) Method for evaluation of removal rate

The removal rate was calculated from the layer thicknesses before and after the polishing. For the measurement of the layer thickness, Thin Film Measurement System UV1280SE (manufactured by KLA-Tencor Corporation) was used.

### (6) Evaluation of polishing properties of Blanket wafers

Evaluation was done by using the above-mentioned polishing compounds having the compositions in respective Examples and using the above-mentioned respective Blanket wafers.

Table 2 shows the removal rates (unit: nm/min) of the respective films of SiC and silicon dioxide, obtained by using the Blanket wafers. From the results, it is evident that by using the polishing compound of the present invention, it is possible to polish the SiC layer at a high removal rate, to suppress polishing of the silicon dioxide layer and to have a high removal rate selective ratio of the SiC layer/the silicon dioxide layer. Further, it is evident that when comparing the removal rate of SiC in Examples is compared with that in Comparative Examples, its absolute value is greatly improved.

The dispersion stability of a polishing compound was evaluated by the change in the average secondary particle size between immediately after the preparation and upon expiration of one week. A case wherein the increase in the average secondary particle size was within 50%, was evaluated to be "good", and a case wherein the increase was larger, or gelation resulted, was evaluated to be "no good." With the polishing compound in each of Examples 1 to 19, no aggregate or precipitate was formed, and the dispersion stability was good.

Further, as a result of the microscopic observation, no scratches were observed on each surface of the SiC layer and the silicon dioxide layer used in Examples and Comparative Examples.

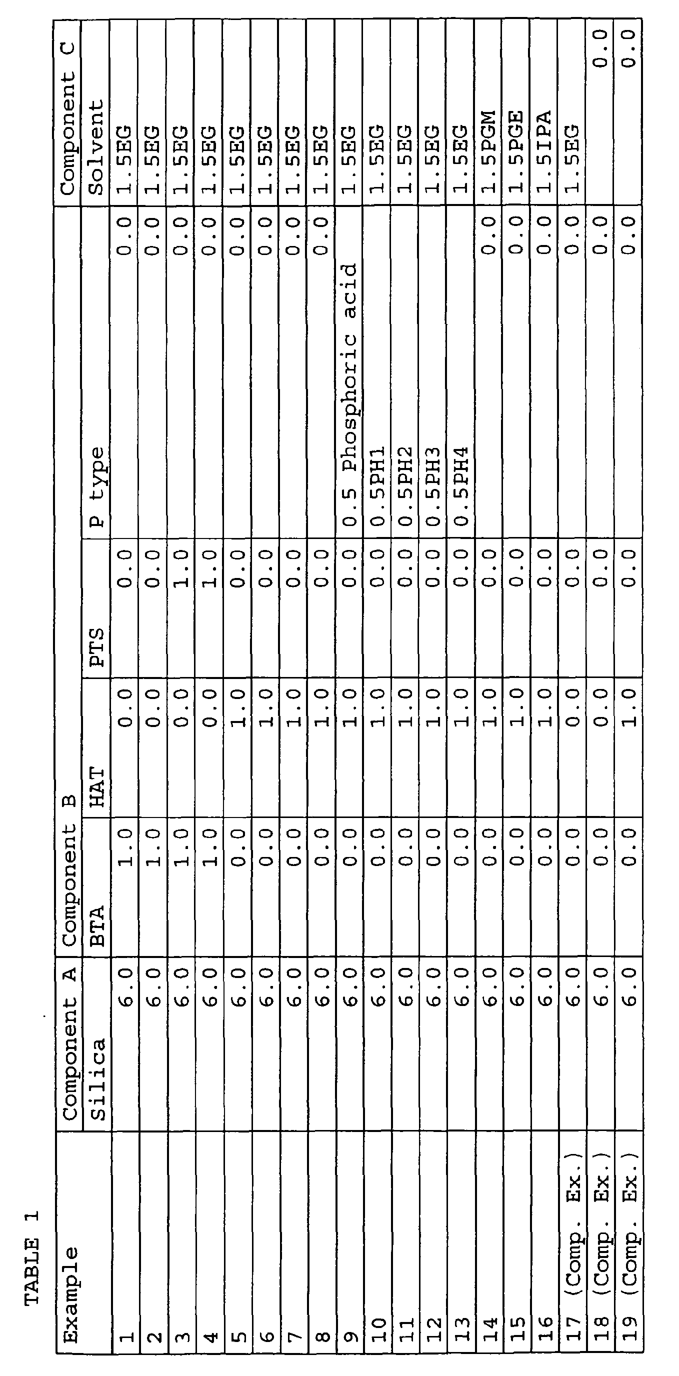

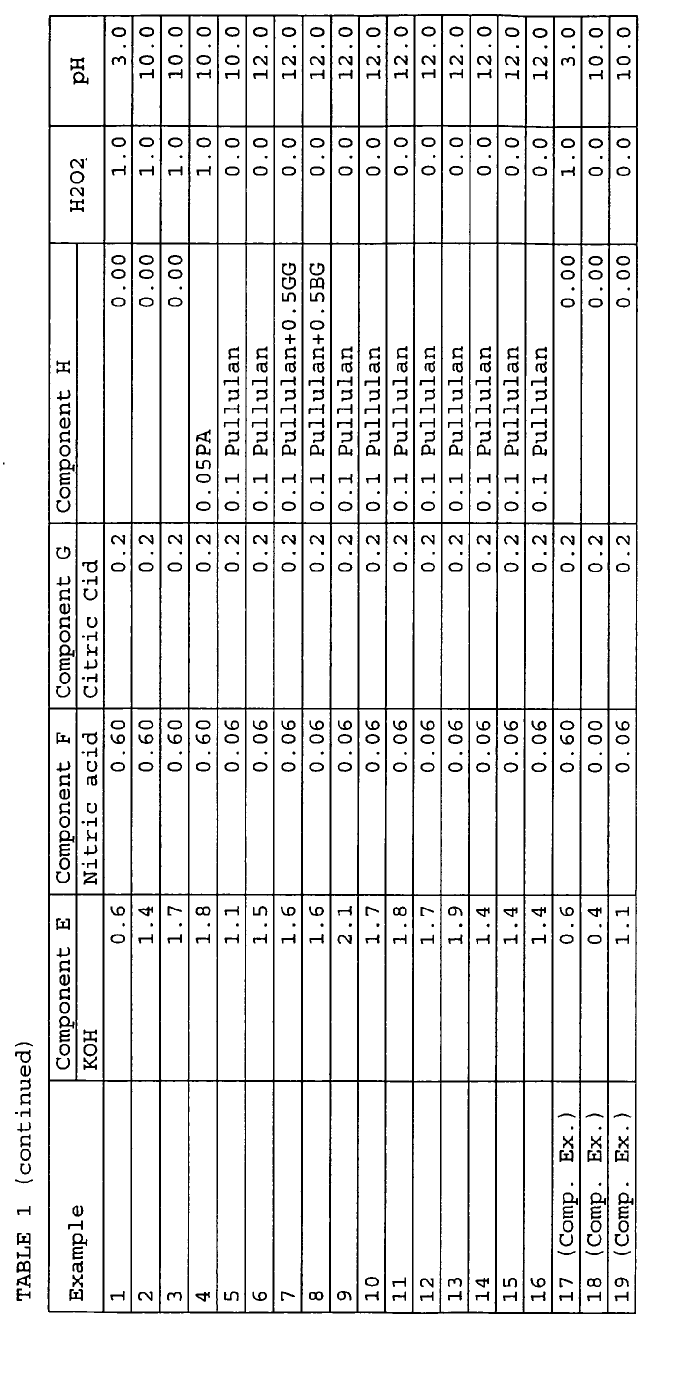

**TABLE 2**

| Example | Removal rte (nm/min) | | SiO layer/ silicon dioxide layer |
|---|---|---|---|
| | SiC | Silicon dioxide | |
| 1 | 59 | 49 | 1.2 |
| 2 | 61 | 14 | 4.4 |
| 3 | 64 | 17 | 3.8 |
| 4 | 62 | 18 | 3.5 |
| 5 | 76 | 17 | 4.5 |
| 6 | 80 | 22 | 3.6 |
| 7 | 97 | 22 | 4.4 |
| 8 | 89 | 23 | 3.8 |
| 9 | 100 | 25 | 4.0 |
| 10 | 88 | 20 | 4.5 |
| 11 | 95 | 21 | 4.5 |
| 12 | 96 | 23 | 4.2 |
| 13 | 100 | 22 | 4.6 |
| 14 | 91 | 21 | 4.4 |
| 15 | 88 | 23 | 3.7 |
| 16 | 92 | 21 | 4.3 |
| 17 (Comp. Ex.) | 22 | 57 | 0.4 |
| 18 (Comp. Ex.) | 20 | 8 | 2.5 |
| 19 (Comp. Ex.) | 37 | 18 | 2.1 |

### INDUSTRIAL APPLICABILITY

The present invention provides a polishing compound for chemical mechanical polishing which is suitable for polishing SiC as a constituting material of e.g. an insulating barrier layer, an etching stopper layer or an antireflection layer; a method for polishing a surface to be polished; and a method for producing a semiconductor integrated circuit device by using the polishing method. The present invention may be effectively applied for micro-fabrication techniques for miniaturization and densification required for the integration and the high functionality of semiconductor integrated circuits.

The entire disclosure of Japanese Patent Application No. 2005-261747 filed on September 9, 2005 including specification, claims, drawings and summary is incorporated herein by reference in its entirety.

## Claims

1. A polishing compound which is a polishing compound for chemical mechanical polishing to polish a SiC-containing surface to be polished in production of a semiconductor integrated circuit device, and which comprises abrasive particles (A); at least one removal rate-adjusting agent (B) selected from the group consisting of a benzotriazole, a 1H-tetrazole, a benzene sulfonic acid, phosphoric acid or an organic phosphonic acid, an organic solvent (C) having a relative dielectric constant of from 15 to 80, a boiling point of from 60 to 250°C and a viscosity of from 0.5 to 60 mPa·s at 25°C; and water (D).

2. The polishing compound according to Claim 1, which further contains a basic compound (E) and has a pH within a range of from 9 to 12.

3. The polishing compound according to Claim 1 or 2, which further contains an inorganic acid (F) and a pH buffer (G).

4. The polishing compound according to any one of Claims 1 to 3, which is used for polishing the surface to be polished which further contains silicon dioxide.

5. The polishing compound according to any one of Claims 1 to 4, wherein the removal rate ratio of SiC layer/silicon dioxide layer is at least 3.

6. The polishing compound according to any one of Claims 1 to 5, wherein the above abrasive particles (A) are colloidal silica.

7. The polishing compound according to any one of Claims 1 to 6, which comprises 0.1 to 20 mass% of the abrasive grains (A), 0.001 to 50 mass% of the removal rate- adjusting agent (B), 0.1 to 20 mass% of the organic solvent (C) and 40 to 98 mass% of water (D), based on 100 mass% of the total mass of the above polishing compound.

8. The polishing compound according to any one of Claims 1 to 7, wherein the above abrasive particles (A) have an average primary particle size in a range of from 5 to 300 nm.

9. The polishing compound according to any one of Claims 1 to 8, which further contains at least one additive (H) selected from the group consisting of polyacrylic acid, pullulan, glycylglycine and N-benzoylglycine.

10. A method for polishing a surface to be polished, which comprises supplying a polishing compound to a polishing pad, and bringing a surface to be polished of a semiconductor integrated circuit device and the polishing pad into contact with each other to polish the surface to be polished by relative movement between them, wherein the surface to be polished is a SiC-containing surface to be polished, and the polishing compound as defined in any one of Claims 1 to 9 is used as the polishing compound.

11. A method for producing a semiconductor integrated circuit device, which comprises a step of polishing a surface to be polished by the polishing method as defined in Claim 10.
